# EUROPÄISCHE PATENTANMELDUNG

(11) **EP 3 244 715 A1**
(43) Veröffentlichungstag der Anmeldung: **15.11.2017**
(21) Anmeldenummer: 16168984.9
(22) Anmeldetag: 10.05.2016
(51) Int. Cl.: H05K 7/14, H01L 25/11

(54) **PHASENMODUL FÜR EINEN STROMRICHTER**

(71) Anmelder: Siemens Aktiengesellschaft, 80333 München (DE)
(72) Erfinder: Boigk, Stefan, 90547 Stein (DE); Böhmer, Jürgen, 90403 Nürnberg (DE); Kleffel, Rüdiger, 91056 Erlangen (DE); Krafft, Eberhard Ulrich, 90419 Nürnberg (DE); Weigel, Jan, 91077 Großenbuch (DE)

(57) **Zusammenfassung**

Die Erfindung betrifft ein Phasenmodul (1) für einen Stromrichter (3) mit einer ersten Stromschiene (11), einer zweiten Stromschiene (12) und mindestens zwei Halbleitermodulen (4), wobei die erste Stromschiene (11) mit Wechselspannungsanschlüssen (41) der Halbleitermodule (4) verbunden ist, wobei die zweite Stromschiene (12) mit Gleichspannungsanschlüssen (42) der Halbleitermodule (4) verbunden ist. Zur Verbesserung des Betriebsverhaltens eines Phasenmoduls (1) mit parallel angeordneten Halbleitermodulen (4) wird vorgeschlagen, die erste und die zweite Stromschiene (11,12) zumindest abschnittsweise in einem Abstand zueinander anzuordnen, dessen Wert die Hälfte des Wertes des Abstandes zwischen Wechselspannungsanschluss (41) und Gleichspannungsanschluss (42) eines der Halbleitermodule (4) unterschreitet. Ferner betrifft die Erfindung einen Stromrichter (3) mit mindestens zwei solchen Phasenmodulen (1), wobei die Wechselspannungsanschlüsse (41) der Phasenmodule (1) die Phasenanschlüsse des Stromrichters (3) bilden. Weiter betrifft die Erfindung ein Verfahren zum Betreiben eines solchen Phasenmoduls (1) oder eines solchen Stromrichters (3), wobei die Ansteuerung der parallel angeordneten Halbleitermodule (4) unabhängig von dem Modulstrom (i₁,i₂,i₃) durch das jeweilige Halbleitermodul (4) erfolgt.

## Beschreibung

Die Erfindung betrifft ein Phasenmodul für einen Stromrichter mit einer ersten und einer zweiten Stromschiene und mindestens zwei Halbleitermodule, wobei die erste Stromschiene mit Wechselspannungsanschlüssen der Halbleitermodule verbunden ist, wobei die zweite Stromschiene mit Gleichspannungsanschlüssen der Halbleitermodule verbunden ist. Die Erfindung betrifft weiter einen Stromrichter sowie ein Verfahren zum Betreiben eines solchen Phasenmoduls oder eines solchen Stromrichters.

Stromrichter werden verwendet um elektrische Verbraucher wie beispielsweise Motoren mit elektrischer Energie zu versorgen. Dabei können Stromrichter an ihren Wechselspannungsausgängen eine Spannung mit variabler Spannungshöhe und variabler Frequenz bereitstellen.

Die einzelnen Wechselspannungsausgänge des Stromrichters werden als Phasen bezeichnet. Die einzelnen Phasen können im Stromrichter durch sogenannte Halbleitermodule gebildet werden.

Ein Halbleitermodul umfasst einen Wechselspannungsanschluss und mindestens zwei Gleichspannungsanschlüsse. Das Halbleitermodul ist allgemein eine Anordnung mit mindestens zwei Halbleiterschaltern, die es ermöglichen, den Wechselspannungsanschluss mit einem der zwei oder mehr Gleichspannungsanschlüssen elektrisch zu verbinden. Durch Schalten der Halbleiterschalter ist im zeitlichen Mittel eine vorgebbare Spannung an dem Wechselspannungsanschluss erzeugbar.

Bei den Halbleiterschaltern handelt es sich beispielsweise um IGBTs, die in Abhängigkeit von ihrer Ansteuerung ihren Schaltzustand (leitend/sperrend) ändern. IGBTs haben die Eigenschaft, mit einer hohen Schaltfrequenz betrieben werden zu können. Eine einfache Ausführung eines Halbleitermoduls mit zwei Gleichspannungspotentialen ist beispielsweise eine sogenannte Halbbrücke. Die Halbbrücke weist eine Reihenschaltung von zwei Halbleiterschaltern auf, wobei der Verbindungspunkt der beiden Halbleiterschalter der Wechselspannungsanschluss ist. Die Gleichspannungsanschlüssen befinden sich an den äußeren Enden der Reihenschaltung.

Um die elektrische Leistungsfähigkeit einer Phase des Stromrichters zu erhöhen, können mehrere Halbleitermodule elektrisch parallel angeordnet werden. Die Modulströme der einzelnen Halbleitermodule addieren sich dabei zu einem Gesamtstrom. Der Modulstrom ist dabei der Strom, der im Betrieb durch das entsprechende Halbleitermodul fließt. Bei der Parallelschaltung, d.h. der elektrisch parallelen Anordnung, der Halbleitermodule werden jeweils die unterschiedlichen Gleichspannungsanschlüsse und die Wechselspannungsanschlüsse der verschiedenen Halbleitermodule beispielsweise mit Hilfe von Stromschienen miteinander verbunden. Eine solche Anordnung wird im Folgenden als Phasenmodul bezeichnet.

Die Stromschienen eignen sich je nach Querschnitt zum Führen von großen Strömen. Im Gegensatz zu Kabeln weisen Stromschienen eine geringe Induktivität auf. Wegen der geringen Induktivität eignen sich die Stromschienen insbesondere für Halbleitermodule, insbesondere für Leistungshalbleiter, die mit einer hohen Schaltfrequenz betrieben werden. Insbesondere zählen heutige IGBT-Module zu der Gruppe von Leistungshalbleitern bzw. Halbleitermodulen, die einen Betrieb mit hoher Schaltfrequenz ermöglichen.

Stromschienen sind dabei zumeist wegen der hohen Leitfähigkeit aus Kupfer hergestellt. Aufgrund der hohen Kupferpreise werden Stromschienen im Hinblick auf Querschnitt und Leitungsweg optimiert, um den Materialeinsatz und damit auch die Kosten für die Verschienung gering zu halten.

Neben Phasenmodule mit zwei Gleichspannungsanschlüssen existieren auch Phasenmodule mit mehr als zwei Gleichspannungspotentialen, insbesondere drei oder fünf Potentialen, zum Aufbau eines 3-Punkt-, 5-Punkt oder, allgemein, n-Punkt-Stromrichters.

In der europäischen Patentanmeldung mit dem Anmeldeaktenzeichen 15 201 849.5 wird eine Stromschienenanordnung offenbart, bei der zwei Stromschienen für die Verbindung mit einem Gleichspannungszwischenkreis weitestgehen überlappend ausgeführt sind, um störende elektrische Felder an den Anschlüssen der Halbleiterschalter zu beseitigen bzw. zu reduzieren. Damit wird ein Schalten der Halbleiterschalter mit hohen Frequenzen ermöglicht.

Der Erfindung liegt die Aufgabe zugrunde, ein Phasenmodul mit elektrisch parallel angeordneten Halbleitermodulen hinsichtlich seines Betriebsverhaltens zu verbessern.

Die Aufgabe wird durch ein Phasenmodul für einen Stromrichter mit einer ersten und einer zweiten Stromschiene und mindestens zwei Halbleitermodulen gelöst, wobei die erste Stromschiene mit Wechselspannungsanschlüssen der Halbleitermodule verbunden ist, wobei die zweite Stromschiene mit Gleichspannungsanschlüssen der Halbleitermodule verbunden ist, wobei die erste und die zweite Stromschiene zumindest abschnittsweise in einem Abstand zueinander angeordnet sind, dessen Wert die Hälfte des Wertes des Abstandes zwischen Wechselspannungsanschluss und Gleichspannungsanschluss eines der Halbleitermodule unterschreitet. Die Aufgabe wird weiter durch einen Stromrichter mit mindestens zwei solchen Phasenmodulen, insbesondere mit drei solchen Phasenmodulen, gelöst, wobei die Wechselspannungsanschlüsse der Phasenmodule die Phasen des Stromrichters bilden. Ferner wird die Aufgabe durch ein Verfahren zum Betreiben eines solchen Phasenmoduls oder eines solchen Stromrichters gelöst, wobei die Ansteuerung der parallel angeordneten Halbleitermodule unabhängig von dem Modulstrom durch den jeweiligen Halbleiterschalter erfolgt.

Vorteilhafte Ausgestaltungen der Erfindung sind in den abhängigen Ansprüchen angegeben.

Der Erfindung liegt die Erkenntnis zugrunde, dass sich die Stromaufteilung zwischen elektrisch parallel angeordneten Halbleitermodulen dadurch verbessern lässt, dass die einzelnen Strompfade durch die Halbleitermodule die gleiche Induktivität aufweisen. Die Strompfade sind Maschen, die sich vom Zwischenkreis über jeweils mindestens ein Halbleitermodul bis zur Last und zurück zum Zwischenkreis erstrecken. Die geringe Induktivität ist insbesondere dann vorteilhaft, wenn die Halbleitermodule mit einer hohen Schaltfrequenz betrieben werden, da dann mit steigender Frequenz die Induktivität einen größeren Einfluss auf die Stromverteilung der einzelnen, parallelen Halbleitermodule hat als die ohmeschen Anteile. Selbst eine geringe Induktivität bzw. geringe Induktivitätsunterschiede haben bei einem Betrieb mit hoher Frequenz, insbesondere im Bereich von Kilohertz (kHz) und darüber, einen relativ hohen Einfluss auf die Stromverteilung (auch als Stromaufteilung bezeichnet) auf die einzelnen Halbleitermodule.

Wenn die Stromzweige durch die parallel angeordneten Halbleitermodule die gleiche Induktivität aufweisen, kann eine gleichmäßige, zumindest eine nahezu gleichmäßige, Stromaufteilung des Gesamtstroms auf die einzelnen Modulströme in den jeweiligen Halbleitermodulen erreicht werden. Die Modulströme der einzelnen parallelen Halbleitermodule sind dann, zumindest nahezu, gleich groß.

Bei der elektrisch parallelen Anordnung der Halbleitermodule sind diese dabei sowohl bezüglich Ihrer Wechselspannungsanschlüsse als auch bezüglich ihrer Gleichspannungsanschlüsse durch die jeweiligen Stromschienen parallel geschaltet.

In der Leistungselektronik wird beim Aufbau von Stromrichtern häufig eine Parallelschaltung von Halbleitermodulen benötigt, um größere Ströme in den einzelnen Phasen führen zu können, als es mit einzelnen Halbleitermodulen möglich ist. Damit ist es darüber hinaus in vorteilhafter Weise möglich, einen Stromrichter modular aufzubauen und über die Anzahl der parallel geschalteten Halbleitermodule zu skalieren und damit an die geforderte Leistungsfähigkeit anzupassen. Als Halbleitermodule kommen dabei vorzugsweise IGBT Module zum Einsatz. Diese sind aufgrund ihrer hohen Schaltfrequenz bei gleichzeitig großer durch das Phasenmodul bzw. durch den Stromrichter zu übertragenden Leistung besonders anfällig für Unterschiede in der Induktivität der Strompfade durch die einzelnen, parallel angeordneten Halbleitermodule. Mit anderen Worten bewirkt eine unterschiedliche Induktivität in den einzelnen Maschen, bzw. den einzelnen Strompfaden durch die unterschiedlichen, parallelen Halbleitermodule, unter anderem aufgrund der hohen Schaltfrequenzen, die im Bereich von Kilohertz (kHz), insbesondere im Bereich von 1kHz bis 20kHz, liegen, eine besonders große Fehlverteilung der Ströme durch die parallelen Halbleitermodule. Eine Fehlverteilung äußert sich in unterschiedlich hohen Modulströmen durch die einzelnen parallel geschalteten Halbleitermodule. Dabei wird die Leistungsfähigkeit der einzelnen Halbleitermodule teilweise nur unbefriedigend ausgenutzt.

Die Induktivität der unterschiedlichen Strompfade ist unter anderem abhängig von der Fläche, die von dem Strompfad des jeweiligen Modulstroms eingeschlossen wird. Es hat sich gezeigt, dass hierbei insbesondere die Flächenanteile von großer Bedeutung sind, die sich in der Nähe der Halbleitermodule befinden.

Um die eingeschlossene Flächen der Strompfade der unterschiedlichen Modulströme, die sich zum Gesamtstrom am Wechselspannungsanschluss addieren, gleich groß zu gestalten, hat es sich als vorteilhaft erwiesen, die erste Stromschiene für die Verbindung der Wechselspannungsanschlüsse und die zweite Stromschiene für die Verbindung von Gleichspannungsanschlüssen zumindest abschnittsweise mit möglichst geringem Abstand zueinander anzuordnen.

Da das Halbleitermodul mindestens zwei Gleichspannungspotentiale aufweist, besitzt es neben diesem Gleichspannungsanschluss auch mindestens einen weiteren Gleichspannungsanschluss, der im Betrieb ein anderes elektrisches Potential aufweist als der Gleichspannungsanschluss. Zur Verbindung dieser weiteren Gleichspannungsanschlüsse kann eine dritte Stromschiene vorgesehen werden. Es hat sich als vorteilhaft erwiesen, auch die dritte Stromschiene möglichst nahe der ersten und zweiten Stromschiene anzuordnen. Dabei kann für den Abstand zwischen erster Stromschiene und dritter Stromschiene das gleiche Kriterium herangezogen werden wie für den Abstand zwischen erster und zweiter Stromschiene. Somit können bei einer vorteilhaften Ausgestaltung der Erfindung die erste und die dritte Stromschiene zumindest abschnittsweise in einem Abstand zueinander angeordnet sein, dessen Wert die Hälfte des Wertes des Abstandes zwischen Wechselspannungsanschluss und weiterem Gleichspannungsanschluss eines der Halbleitermodule unterschreitet.

Die zweite und dritte Stromschiene sind elektrisch isoliert voneinander ausgeführt, da sie im Betrieb unterschiedliche elektrische Potentiale aufweisen.

Bisher erfolgt die Anordnung der Stromschienen in erster Linie aus dem Gesichtspunkt des Materialeinsatzes. Daher werden die Stromschienen für Wechselspannungsanschluss und Gleichspannungsanschluss in etwa in dem Abstand angeordnet, der unter Vernachlässigung der Breite der Stromschien dem Abstand von Wechselspannungsanschluss und Gleichspannungsanschluss am Halbleitermodul entspricht. Werden die Stromschienen nun deutlich näher zueinander angeordnet, ist insbesondere schon bei einer Halbierung des Abstandes eine Anpassung der Induktivitäten der Strompfade (Maschen) der einzelnen Modulströme zu beobachten, die zu einer deutlich besseren Stromaufteilung zwischen den Halbleitermodulen führt. Damit sinkt die Fehlverteilung zwischen den einzelnen Halbleitermodulen. Ein noch geringerer Abstand führt zu einer weiteren Verbesserung der Stromaufteilung bzw. zu einer weiteren Reduktion der Fehlverteilung.

Der Vorteil des Phasenmoduls besteht insbesondere darin, dass durch den verringerten Abstand der Einfluss der induktiv bedingten Spannungen (Selbstinduktion und induktive Kopplung) auf die Modulströme durch die parallel geschalteten Halbleitermodule, insbesondere der IGBTs, minimiert wird. Ohmsche Anteile und an diesen ohmschen Anteilen entstehende Spannungen dominieren dann. Dadurch wird eine gleichmäßigere Stromaufteilung auf die einzelnen Halbleitermodule in der Parallelschaltung erreicht. Die Ausnutzung der Strombelastbarkeit der Halbleitermodule, insbesondere der IGBT-Module, kann somit verbessert und eine Überdimensionierung der Halbleitermodule reduziert werden oder sogar ganz entfallen. Außerdem wird die Abhängigkeit der Stromaufteilung in der Parallelschaltung von der Führung der Leitung für den Laststrom minimiert oder beseitigt, so dass die Dimensionierung der Halbleitermodule und die Verlegung der Verbindungsleitungen zur Last des Stromrichters oder des Phasenmoduls unabhängig voneinander vorgenommen werden können.

Besonders vorteilhaft ist es, wenn die Querschnitte der Stromschienen, die wesentlich die Stromtragfähigkeit der Stromschiene bestimmen, ausgelegt sind auf die Stromtragfähigkeit der Halbleitermodule. Damit kann eine besonders günstige Ausnutzung des teuren Kupfermaterials für die Stromschiene erreicht werden.

Mehrere Phasenmodule können zu einem Stromrichter kombiniert werden. Die Wechselspannungsanschlüsse der unterschiedlichen Phasenmodule bilden dabei eine Phase des Stromrichters. Somit benötigt beispielsweise ein dreiphasiger Stromrichter drei Phasenmodule um diese drei Phasen zu realisieren. An die Phasen des Stromrichters wird die Last angeschlossen. Eine typische Last für einen Stromrichter sind ein oder mehrere Motoren. Ein einphasiger Stromrichter kann auf einfache Weise beispielsweise durch die Verwendung eines Phasenmoduls gebildet werden.

Die Gleichspannungsanschlüsse der Phasenmodule werden zur Bildung des Stromrichters jeweils mit dem Zwischenkreis des Stromrichters, insbesondere mit dem Zwischenkreiskondensator, verbunden.

Da durch die erfindungsgemäße Anordnung sich der Gesamtstrom gleichmäßig, zumindest nahezu gleichmäßig, auf die einzelnen Modulströme aufteilt, kann auf regelungstechnische Maßnahmen zur Regelung der Stromaufteilung verzichtet werden. Somit kann die Ansteuerung der Halbleitermodule unabhängig von dem Modulstrom durch das jeweilige Halbleitermodul erfolgen.

Bei einer vorteilhaften Ausgestaltung der Erfindung sind die erste und die zweite Stromschiene zumindest abschnittsweise in einem Abstand zueinander angeordnet, dessen Wert in der Größenordnung liegt, die eine sichere Isolation zwischen der ersten und zweiten Stromschiene sicherstellt. Die einfachste Art der Isolierung wird durch Luft zwischen den Stromschienen sichergestellt. Der Luftspalt zwischen den Stromschienen, bzw. der Abstand der Stromschienen (Luftstrecke) zueinander, wird dabei so groß gewählt, dass es zu keinen Überschlägen zwischen den Stromschienen kommen kann. Das hat den Vorteil, dass die Stromschienen dann besonders nah und kompakt angeordnet sind. Damit ist eine besonders gute Stromaufteilung realisierbar, da die von den Modulströmen aufgespannten Flächen nahezu identisch sind. Durch Verbinder können die Stromschienen aneinander fixiert werden. Dadurch sind die Stromschienen insbesondere während der Montage leicht handhabbar und montierbar. Der Verbinder kann aufgrund des geringen Abstands zwischen den Stromschienen besonders klein und kompakt ausgeführt sein. Der Verbinder weist isolierendes Material auf, um einen Stromfluss zwischen den Stromschienen durch den Verbinder zu verhindern.

Um einen Überschlag, d.h. einen unerwünschten Stromfluss zwischen der ersten und der zweiten Stromschiene, auch unter widrigen Umweltbedingungen, wie beispielsweise bei besonders feuchter oder verunreinigter Luft, sicherzustellen, hat es sich als sinnvoll erwiesen, den Abstand zwischen der ersten und der zweiten Stromschiene mit einem Sicherheitszuschlag zu versehen. Somit wird vorgeschlagen, dass der Abstand zwischen der ersten und der zweiten Stromschiene in einer Größenordnung liegt, die eine sichere Isolation sicherstellt. Unter der Größenordnung versteht der Fachmann auch Abstände, die bis zum Faktor 10 größer sind, als es für die Isolation mit Luft unter normalen oder idealen Umständen erforderlich wäre.

Bei einer weiteren vorteilhaften Ausgestaltung der Erfindung sind die erste und die zweite Stromschiene zumindest abschnittsweise in einem Abstand zueinander angeordnet, dessen Wert den Wert der Breite oder Dicke der ersten und/oder zweiten Stromschiene unterschreitet. Diese Anordnung ergibt eine besonders kompakte Bauform der Stromschienen. Dabei können die Stromschienen elektrisch aneinander isoliert befestigt sein, so dass die Montage der Stromschienen an die Halbleitermodule besonders einfach erfolgen kann. Falls ein im Betrieb vorgesehener Potentialunterschied zwischen den Phasen einen größeren Abstand zwischen der ersten und zweiten Stromschiene erfordern würde, so kann zwischen den Stromschienen ein Isoliermaterial, beispielsweise ein Kunststoff oder eine Keramik, eingebracht werden. Dies erlaubt eine sichere Isolation der Stromschienen voneinander auch bei geringerem Abstand im Vergleich zur Verwendung von Luft als Isolationsmedium.

Bei einer weiteren vorteilhaften Ausgestaltung der Erfindung sind im Bereich der Halbleitermodule die erste und die zweite Stromschiene parallel zueinander angeordnet. Das parallele Anordnen der Stromschienen bietet insbesondere dann Vorteile, wenn die Stromschienen mechanisch miteinander verbunden sind. In diesem Fall können über die Länge der Stromschiene die gleichen Verbinder eingesetzt werden, um die Stromschienen aneinander zu fixieren. Alternativ oder ergänzend können die Stromschienen mittels eines zwischen den Stromschienen angeordneten Isolators oder eines Isoliermaterials miteinander verbunden sein. Die parallele Anordnung der Stromschienen erfordert einen Isolator mit konstanter Dicke, der besonders einfach herstellbar ist. Darüber hinaus ist ein Isolator mit konstanter Dicke einfach zwischen die Stromschienen anordenbar.

Der Bereich der Halbleitermodule, in der eine parallele Anordnung besonders vorteilhaft ist, umfasst insbesondere den Bereich der Stromschienen, der zwischen den Anschlüssen der Stromschienen zur Verbindung mit den Halbleitermodulen liegt.

Bei einer weiteren vorteilhaften Ausgestaltung der Erfindung ist zwischen der ersten Stromschiene und der zweiten Stromschiene ein Isoliermaterial angeordnet ist. Die Verwendung von Isoliermaterial zwischen der ersten und der zweiten Stromschiene bietet mehrere Vorteile. Zum einen können die Stromschienen durch die isolierende Wirkung des Isoliermaterials mit besonders geringem Abstand zueinander angeordnet werden. Darüber hinaus bietet das Isoliermaterial die Möglichkeit, die Stromschienen aneinander zu fixieren und so eine kompakte, leicht zu montierende Einheit zu schaffen. Mit dem Isoliermaterial können die Stromschienen auf einfache Weise parallel zueinander angeordnet werden. Darüber hinaus kann das Isoliermaterial Korrosion zwischen den Stromschienen verhindern.

Bei einer weiteren vorteilhaften Ausgestaltung der Erfindung weist die erste und/oder die zweite Stromschiene mindestens einen Steg auf, der rechtwinklig am übrigen Teil der Stromschiene angeordnet ist und die Stromschiene mit mindestens einem der Gleichspannungsanschlüsse oder einem der Wechselspannungsanschlüsse eines der Halbleitermodule verbindet, wobei der Steg entlang einer Oberfläche des einen Halbleitermoduls angeordnet ist. Bei dieser Ausführungsform lassen sich die Stromschienen auf besonders einfache Weise parallel und in geringem Abstand zueinander anordnen. Der Bereich der Anschlüsse wird durch Stege gebildet. Dabei können Unterschiede in der Positionierung der Anschlüsse am Halbleitermodul auf einfache Weise durch die Ausgestaltung des Stegs ausgeglichen werden. Der Strom durch das Halbleitermodul (Modulstrom) wird durch den entsprechenden Steg wieder zu dem Bereich der mit geringem Abstand angeordneten Stromschienen zurückgeführt. Dieser Bereich der Stromschiene, der sich außerhalb der Stege befindet, ist als übriger Teil der Stromschiene bezeichnet. Da der Steg entlang der Oberfläche des Halbleitermoduls angeordnet ist, verlaufen die Ströme durch das Modul und durch den entsprechenden Steg nahezu parallel. Diese nahezu parallele Stromführung bewirkt eine gegenseitige Kompensation von magnetischen Feldern, so dass durch den Modulstrom nahezu kein Magnetfeld erzeugt wird, das auf die Ströme durch die anderen Halbleitermodule wirkt. Damit wird eine besonders gute magnetische Entkopplung der einzelnen Modulströme erreicht. Mit anderen Worten ist die induktive Kopplung zwischen den einzelnen Modulströmen in dieser Ausführung besonders gering. Da eine induktive Kopplung zwischen den einzelnen Modulströmen zu einer Fehlverteilung der Ströme auf die einzelnen Halbleitermodule führt, kann durch diese Ausführungsform eine besonders gleichmäßige Aufteilung der Ströme auf die Halbleitermodule erreicht werden.

Bei einer weiteren vorteilhaften Ausgestaltung der Erfindung sind die erste Stromschiene und die zweite Stromschiene in der Umgebung der Halbleitermodule zumindest teilweise überlappend angeordnet. Die überlappende Anordnung schafft die Möglichkeit, eine kompakte Stromschienenanordnung zu schaffen, die auf besonders einfache Weise bei der Montage eines Phasenmoduls eingesetzt werden kann. Die überlappende Anordnung schafft darüber hinaus, insbesondere wenn ein Isoliermaterial zwischen den Stromschienen angeordnet ist, einen besonders stabilen Aufbau für die Stromschiene. Dieser Aufbau ist insbesondere verwindungssteif und kann somit auch Kräfte, wie beispielsweise Gewichtskräfte der Halbleitermodule, ganz oder teilweise aufnehmen. Darüber hinaus können die Stromschienen zur Gesamtstabilität des mechanischen Aufbaus des Phasenmoduls beitragen, so dass für die Konstruktion Material zur Herstellung einer hohen Stabilität, wie es beispielsweise der Einsatz auf Fahrzeugen erfordert, eingespart werden kann. Somit lässt sich durch die überlappende Anordnung eine im Hinblick auf das Gewicht besonders stabile und/oder verwindungssteife Konstruktion erzielen.

Darüber hinaus lassen sich die Stromschienen besonders einfach parallel anordnen. Ein weiterer Vorteil besteht darin, auf einfache Weise mittels entsprechender Verbinder und/oder einer zwischen den Stromschienen angeordneten Isolierschicht die Stromschienen miteinander zu verbinden und somit eine besonders stabile bauliche Einheit zu schaffen.

Darüber hinaus kompensieren die Ströme durch die unterschiedlichen Stromschienen die entstehenden Magnetfelder. Dadurch wird die magnetische Kopplung zu anderen Schaltkreisen oder anderen Phasenmodulen des Stromrichters weitestgehend reduziert. Durch die überlappende Anordnung ist die für die Induktivität des Stromkreises wirksame Fläche der einzelnen Modulströme gleich groß. Dies führt zu einer gleichmäßigen Aufteilung des Gesamtstroms auf die einzelnen Modulströme.

Bei einer weiteren vorteilhaften Ausgestaltung der Erfindung weist das Phasenmodul eine dritte Stromschiene auf, wobei die dritte Stromschiene mit weiteren Gleichspannungsanschlüssen der Halbleitermodule verbunden ist, wobei die erste Stromschiene, die zweiter Stromschiene und die dritte Stromschiene in der Umgebung der Halbleitermodule zumindest teilweise überlappend angeordnet sind. Durch diese Art der Verschienung ergibt sich eine kompakte Stromschienenanordnung um ein Phasenmodul mit zwei Gleichspannungsanschlüssen und einem Wechselspannungsanschluss auf besonders einfache Weise elektrisch zu kontaktieren. Mit dem überlappenden Aufbau dreier Stromschienen erreicht die Stromschienenanordnung eine große Dicke, welche erheblich zu einem stabilen Aufbau beiträgt. Darüber hinaus ist dieser Aufbau besonders kompakt. Somit kann auch das entsprechende Phasenmodul besonders klein und raumsparend aufgebaut werden. Der Bereich hoher Feldstärken aufgrund der unterschiedlichen Potentiale ist innerhalb eines Stromrichters damit sehr gering und auf die unmittelbare Umgebung des Stromschienenpakets beschränkt und kann insbesondere bei der Verwendung von Isoliermaterialien zwischen den Stromschienen auf einfache und kostengünstige Weise beherrscht werden.

Bei einer weiteren vorteilhaften Ausgestaltung der Erfindung sind die Stromschienen derart angeordnet, dass im Betrieb des Phasenmoduls die durch die jeweiligen Maschen der Modulströme der einzelnen Halbleitermodule aufgespannten Flächen im Wesentlichen identisch sind. Die Maschen ergeben sich aus den Stromwegen der einzelnen Modulströme. Die Stromwege werden durch die Stromschienen und durch die Leitungen zu einer Last gebildet. Die Leitungen zur Last haben jedoch meist keinen Einfluss auf die wirksame Fläche, da die verschiedenen Phasen in unmittelbarer Nähe zueinander geführt werden. Somit wird die wirksame Fläche insbesondere durch die Stromschienen im Bereich der Halbleitermodule beeinflusst. Durch eine Anordnung, beispielsweise durch eine eng beabstandete Führung der Stromschienen zueinander, kann der Unterschied in den wirksamen Flächen so weit reduziert werden, dass eine gleichmäßige Aufteilung der Ströme auf die einzelnen Halbleitermodule eines Phasenmoduls bewirkt wird.

Bei einer weiteren vorteilhaften Ausgestaltung der Erfindung werden die parallel angeordneten Halbleitermodule synchron angesteuert. Da die Stromaufteilung auf die einzelnen Halbleitermodule aufgrund der baulichen Gegebenheiten bereits nahezu gleich ist, kann auf spezielle regelungstechnische Eingriffe zur Beeinflussung der Stromaufteilung verzichtet werden. Eine solche Beeinflussung kann dadurch erreicht werden, dass die parallel angeordneten Halbleitermodule unabhängig voneinander angesteuert werden. Dies erfordert eine separate Ansteuerung der Halbleitermodule, wobei die Ansteuerung auf der Basis von gemessenen Modulströmen erfolgt. Durch die gleichmäßige Aufteilung des Gesamtstroms auf die einzelnen Modulströme kann auf eine derartige regelungs- oder steuerungstechnische Beeinflussung der Modulströme verzichtet werden. Auch bei einer synchronen Ansteuerung kann durch die nahezu gleichen Induktivitätsverhältnisse, sowohl in Bezug auf Selbstinduktion wie auch in Bezug auf induktive Kopplung, eine gleichmäßige Stromaufteilung erreicht werden. Der Vorteil besteht darin, dass keine Messwerte der unterschiedlichen Modulströme ausgewertet werden müssen. Somit kann auf die Bestimmung von Messwerten wie auch eine Verarbeitung und/oder Auswertung dieser Daten verzichtet werden. Somit werden keine separaten Ansteuerbaugruppen für die parallelen Halbleitermodule benötigt, da die Halbleitermodule synchron, d.h. zeitgleich, angesteuert werden.

Im Folgenden wird die Erfindung anhand der in den Figuren dargestellten Ausführungsbeispiele näher beschrieben und erläutert. Es zeigen:
- FIG 1: ein Schaltbild einer Parallelschaltung dreier Halbleitermodule,
- FIG 2: einen typischen Aufbau eines Halbleitermoduls,
- FIG 3: eine bekannte Anordnung von Halbleitermodulen und Stromschienen,
- FIG 4: einen räumlichen Verlauf der Strompfade,
- FIG 5: wirksame Flächen der Strompfade,
- FIG 6: ein Ausführungsbeispiel für die Anordnung zweier Stromschienen,
- FIG 7: ein Ausführungsbeispiel für Stromschienen mit Stegen und
- FIG 8: wirksame Flächen der Strompfade des zuvor beschriebenen Ausführungsbeispiels.

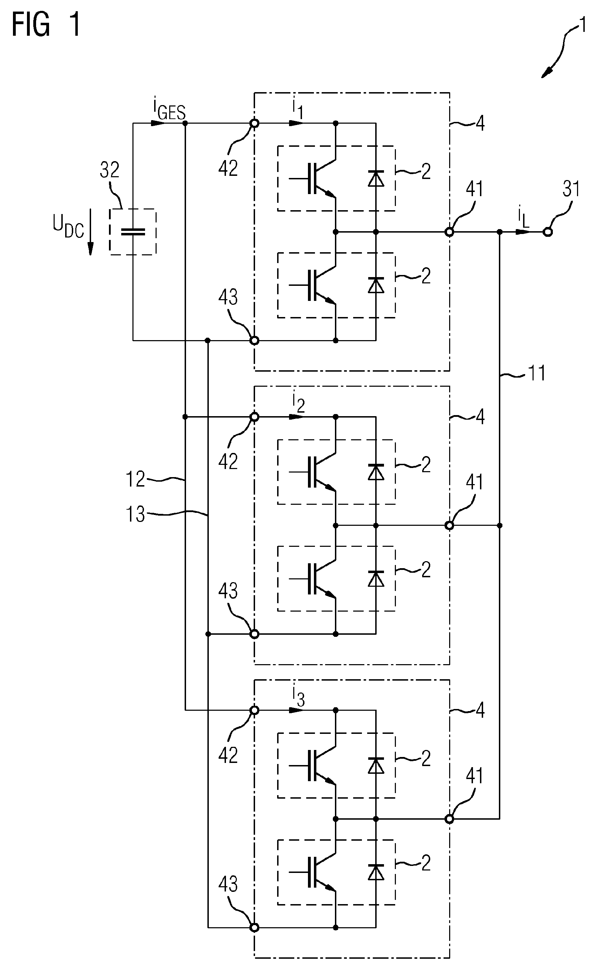

FIG 1 zeigt ein Ausführungsbeispiel einer Schaltung, bei der drei Halbleitermodule 4 in einer Parallelschaltung angeordnet sind. Die Parallelschaltung wird bezüglich ihrer Wechselspannungsanschlüsse 41 vorgenommen, die beispielsweise eine Phase 31 eines Stromrichters 3 bilden können. Die Wechselspannungsanschlüsse 41 sind dabei mittels einer ersten Stromschiene 11 miteinander verbunden. Diese Figur gibt dabei nur die Schaltung, d.h. die elektrische Verbindung, an. Die Darstellung dieser Figur trifft kleine Aussage über die Lage der einzelnen Komponenten im Raum.

Gleichspannungsseitig weist jedes Halbleitermodul 3 einen Gleichspannungsanschluss 42 und einen weiteren Gleichspannungsanschluss 43 auf, die jeweils mit einem Potential des Zwischenkreises verbunden sind. Die Differenz der Potentiale ist die Zwischenkreisspannung U_{DC}. Diese liegt am Zwischenkreiskondensator 32 an. Die Gleichspannungsanschlüsse 42 bzw. weiteren Gleichspannungsanschlüsse 43 werden jeweils über eine zweite Stromschiene 12 und eine dritte Stromschiene 13 miteinander verbunden. Dabei ist es unerheblich, ob die Gleichspannungsanschlüsse 42 das positive Potential des Zwischenkreises darstellen (wie in der FIG 1 abgebildet) oder das negative. Gleiches gilt für die weiteren Gleichspannungsanschlüsse 43 sowie für die zweite und dritte Stromschiene 12, 13.

In einem einfachen Fall, in dem der Zwischenkreis zwei unterschiedliche Potentiale aufweist, umfasst jedes der Halbleitermodule 4 jeweils mindestens zwei Halbleiterschalter 2, die den Wechselspannungsausgang 41 mit dem Gleichspannungsanschluss 42 oder dem weiteren Gleichspannungsanschluss 43 elektrisch verbinden können. Der Gesamtstrom i_{GES} des Zwischenkreises teilt sich dabei auf die Modulströme i₁, i₂, i₃ durch die einzelnen Halbleitermodule 4 auf und bilden den Laststrom i_{L}, der zu einer nicht dargestellten Last 5 fließt. Getrieben wird der Strom durch die Zwischenkreisspannung U_{DC}.

In dem dargestellten Beispiel fließt der Strom jeweils durch die oberen der dargestellten Halbleiterschalter 2. Je nach Betriebszustand kann der Stromfluss jedoch auch durch die unteren Halbleiterschalter 2 erfolgen.

Eine solche Parallelschaltung findet oftmals dann Anwendung, wenn basierend auf vorhandenen Halbleitermodulen 4 die Leistungsfähigkeit eines Phasenmoduls 1, insbesondere ein Phasenmodul 1, das eine Phase eines Stromrichters 3 bildet, erhöht werden soll.

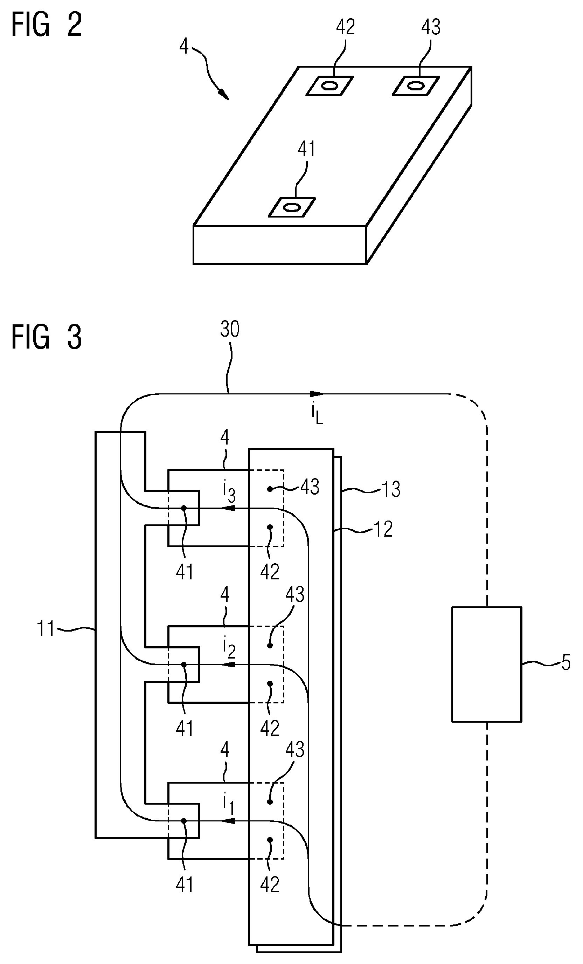

Die FIG 2 zeigt eine typische Anordnung von Anschlüssen 41, 42, 43 an einem Halbleitermodul 4. Dabei befinden sich die Anschlüsse 41, 42, 43 zumeist alle auf einer Fläche des Halbleitermoduls, die auch als Oberseite des Halbleitermoduls bezeichnet wird. Dort sind die Gleichspannungsanschlüsse 42 sowie die weiteren Gleichspannungsanschlüsse 43 oftmals an einem Rand dieser Oberfläche angeordnet und die Wechselspannungsanschlüsse 41 räumlich getrennt, vorzugsweise an dem gegenüberliegenden Rand, der Oberseite angeordnet. Die Anschlüsse 42, 43 können dabei auch getauscht sein. Insbesondere bei modernen IGBT-Halbbrückenmodulen sind oft die gleichspannungsseitigen Anschlüsse 42, 43 auf der einen und der wechselspannungsseitige Anschluss 41 auf der anderen Seite des Gehäuses angeordnet.

Die FIG 3 zeigt den bereits bekannten typischen Aufbau von Halbleitermodulen 4 und Stromschienen 11, 12, 13. Eine Parallelschaltung von Halbleitermodulen 4 führt zu einer Anordnung, wie in dieser Figur dargestellt ist. Die erste Stromschiene 11 verbindet die Wechselspannungsanschlüsse 41, die zweite Stromschiene 12 die Gleichspannungsanschlüsse 42 und die dritte Stromschiene 13 die weiteren Gleichspannungsanschlüsse 43. Im Bereich der Anschlüsse ist insbesondere bei der zweiten und dritten Stromschiene dafür Sorge zu tragen, dass die unterschiedlichen Anschlüsse 42, 43 isoliert voneinander sind. Dies wird beispielsweise durch Löcher in der jeweiligen Stromschiene 12, 13 sichergestellt, die auf der den Halbleitermodulen 4 zugewandten Seite verlegt ist. Die Halbleitermodule 4 führen dabei den jeweiligen Modulstrom i₁, i₂, i₃, der sich zum Laststrom i_{L} überlagert, d.h. addiert. Dabei bilden sich durch die einzelnen Halbleitermodule 4 und die Last 5 geschlossene Strompfade, die als Maschen 30 bezeichnet werden und im Bereich der Halbleitermodule 4 in der FIG 3 gekennzeichnet sind. Der genaue Verlauf in der Nähe der Last 5 und zurück zum Zwischenkreis, bzw. seiner Stromschienen 12, 13 ist dabei nicht erheblich und wird daher als gestrichelter Bereich dargestellt.

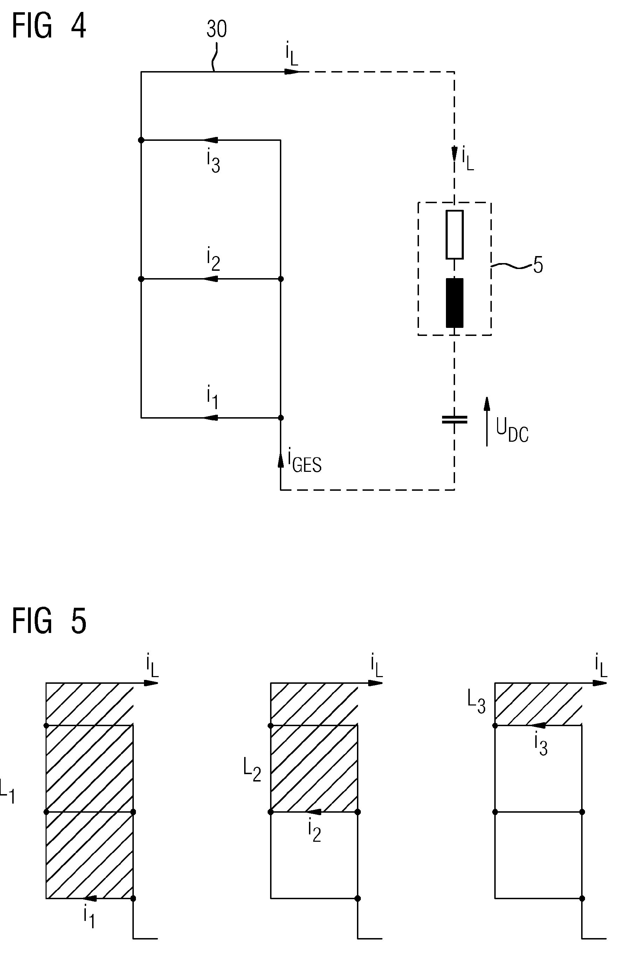

Die FIG 4 zeigt die räumliche Verteilung der einzelnen Modulströme i₁, i₂, i₃, wie sie sich aus einer Anordnung nach FIG 3 ergibt. Betrachtet man die eingeschlossenen Flächen der einzelnen Maschen 30, so kann leicht erkannt werden, dass diese im Bereich der Halbleitermodule (durchgezogene Linie der Masche 30) unterschiedlich große Flächen bilden. Die Unterschiede werden in der FIG 5 noch einmal genauer dargestellt. Die eingeschlossene Fläche hat dabei einen Einfluss auf die Größe der Induktivität L₁, L₂, L₃ der entsprechenden Masche 30, bzw. des entsprechenden Strompfades. Durch die unterschiedlichen Flächen, die in der FIG 5 für die einzelnen Modulströme i₁, i₂, i₃ dargestellt sind, ergeben sich auch unterschiedliche Induktivitäten in den unterschiedlichen Strompfaden. Diese Flächen sind außerdem von der Lage der Leitung für den Laststrom I_{L} abhängig und untereinander magnetisch gekoppelt. In der Folge ergeben sich bei zeitlichen Änderungen des Laststroms ungleiche Aufteilungen des Laststroms auf die parallel geschalteten Halbleitermodule 4, insbesondere bei der Verwendung von IGBT-Modulen. Dadurch werden die parallel geschalteten IGBT-Module unterschiedlich stark mit Strom belastet und können in ihrer jeweiligen Strombelastbarkeit nicht vollständig ausgenutzt werden.

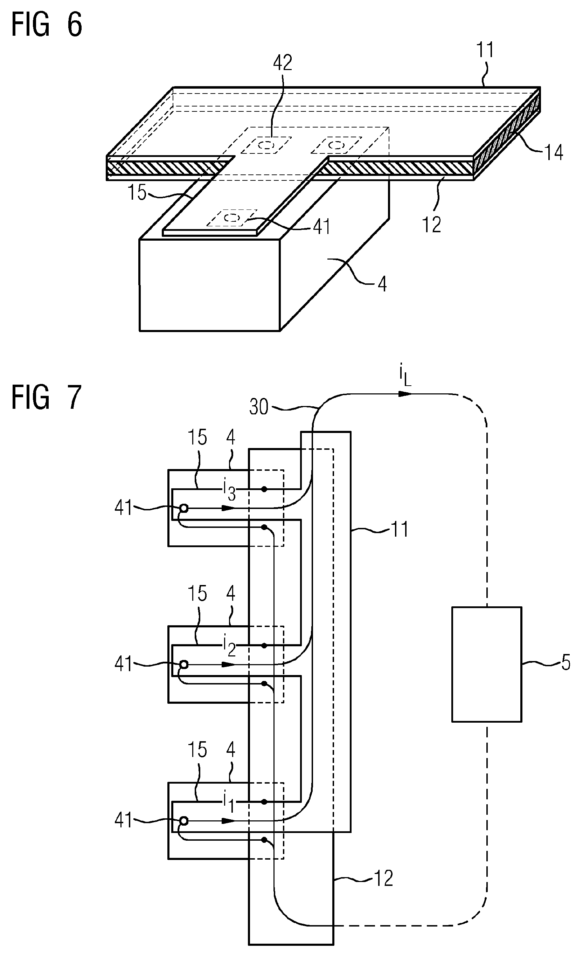

Bei einer Ausführungsform der Erfindung werden daher zumindest die erste Stromschiene 11 und die zweite Stromschiene 12 räumlich nahe zueinander angeordnet. Bei dem in FIG 6 dargestellten Ausführungsbeispiel sind diese Stromschienen 11, 12 überlappend angeordnet. Zur Verbesserung der Isolation dieser Stromschienen 11, 12 kann zwischen diesen ein Isoliermaterial 14 angeordnet werden. Damit ist ein besonders kleiner Abstand zwischen zwei Stromschienen auch bei großen Potentialunterschieden möglich. Im Bereich des Anschlusses, der nicht in der Nähe des überlappenden Bereichs liegt, weist die dargestellte erste Stromschiene 11 einen Steg 15 auf, der die elektrische Verbindung mit dem Wechselspannungsanschluss 41 sicherstellt. Alternativ oder ergänzend ist es möglich, auch die Verbindung der Gleichspannungsanschlüsse 42 und/oder weiteren Gleichspannungsanschlüsse 43 mit Stegen 15 an den entsprechenden Stromschienen 12, 13 vorzunehmen. Dies erhöht den Freiheitsgrad in der räumlichen Anordnung der eng beabstandeten Stromschienen 11, 12, 13.

Durch die Anordnung des Stegs 15 entlang der Oberfläche des Halbleitermoduls 4 wird außerdem sichergestellt, dass ein Modulstrom i₁, i₂, i₃ durch das Halbleitermodul 4 nahezu parallel wieder zurück zum Bereich der Stromschienen geführt wird. Diese zumindest nahezu parallele Stromführung bewirkt ein geringes Magnetfeld und somit auch eine geringe magnetische Kopplung mit den Modulströmen der übrigen Halbleitermodule 4.

Eine Anordnung mit parallel angeordneten Halbleitermodulen 4, die über Stromschienen 11, 12 miteinander verbunden sind, zeigt FIG 7. Bei diesem Ausführungsbeispiel sind die erste Stromschiene 11 und die zweite Stromschiene 12 mit geringem Abstand zueinander angeordnet. Durch die Stege 15 der Stromschiene 11 erfolgt der Strompfad vom Wechselspannungsanschluss 41 des Halbleitermoduls 4 nahezu parallel zum Stromfluss im Innern des Halbleitermoduls 4.

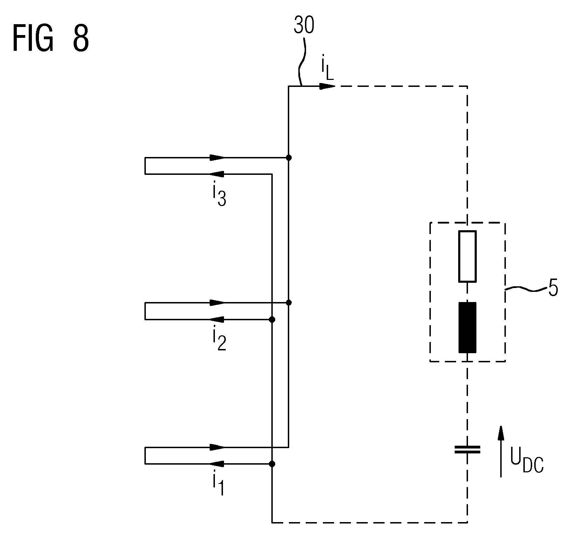

Damit werden die Flächen, die in FIG 8 dargestellt sind und von den jeweiligen Strompfaden, bzw. durch die einzelnen Maschen 30, durch die einzelnen parallel geschalteten Halbleitermodule 4 mit der Leitung für den Laststrom I_{L} gebildet werden, minimiert oder beseitigt. Die Maschen 30 der einzelnen Modulströme i₁, i₂, i₃ weisen nun jeweils die gleiche Flächen auf, da durch die Führung des Stroms durch die Stege 15 keine oder nahezu keine Flächen im Bereich der Halbleitermodule 4 aufgespannt werden. Dies liegt daran, dass die Wechselspannungsanschlüsse 41 der Halbleitermodule 4 direkt über dem jeweiligen Modul in Richtung zu den gleichspannungsseitigen Anschlüssen 42, 43 zurückgeführt werden. Dadurch entstehen weder Flächenunterschiede in den unterschiedlichen Maschen 30 noch entsteht durch die parallele Stromführung durch das Halbleitermodul 4 und zurück zum überlappenden Bereich der Stromschienen ein Magnetfeld, welches störend auf die übrigen Modulströme einwirken kann. Selbst wenn die Entstehung eines Magnetfeldes nicht verhindert werden kann, ist dieses derart klein, dass eine nennenswerte Auswirkung auf die übrigen Modulströme und die Aufteilung der Modulströme nicht vorhanden ist. Die einzelnen rückgeführten Wechselspannungsanschlüsse 41 werden dann durch die erste Stromschiene 11, die in der Nähe, insbesondere oberhalb der zweiten und/oder dritten Stromschiene 12, 13 angeordnet ist, miteinander verbunden. Dabei ist es vorteilhaft, die Abstände zwischen der ersten Stromschiene 11, die mit den Wechselspannungsanschlüssen 41 verbunden ist, und den Halbleitermodulen 4 und/oder der zweiten/dritten Stromschiene 12, 13 so klein wie möglich zu gestalten. Dadurch werden die Flächen, die von Hin- und Rückstrom durch jedes einzelne Modul eingeschlossen werden, minimiert und sind nun unabhängig von der Verlegung der Anschlussleitung für den Laststrom i_{L}. Darüber hinaus werden die magnetischen Kopplungen zwischen diesen Flächen minimiert. Damit wird eine magnetische Entkopplung der einzelnen Modulströme i₁, i₂, i₃ voneinander erreicht.

Zusammenfassend betrifft die Erfindung ein Phasenmodul für einen Stromrichter mit einer ersten Stromschiene, einer zweiten Stromschiene und mindestens zwei Halbleitermodulen, wobei die erste Stromschiene mit Wechselspannungsanschlüssen der Halbleitermodule verbunden ist, wobei die zweite Stromschiene mit Gleichspannungsanschlüssen der Halbleitermodule verbunden ist. Zur Verbesserung des Betriebsverhaltens eines Phasenmoduls mit parallel angeordneten Halbleitermodulen wird vorgeschlagen, die erste und die zweite Stromschiene zumindest abschnittsweise in einem Abstand zueinander anzuordnen, dessen Wert die Hälfte des Wertes des Abstandes zwischen Wechselspannungsanschluss und Gleichspannungsanschluss eines der Halbleitermodule unterschreitet. Ferner betrifft die Erfindung einen Stromrichter mit mindestens zwei solchen Phasenmodulen, wobei die Wechselspannungsanschlüsse der Phasenmodule die Phasenanschlüsse des Stromrichters bilden. Weiter betrifft die Erfindung ein Verfahren zum Betreiben eines solchen Phasenmoduls oder eines solchen Stromrichters, wobei die Ansteuerung der parallel angeordneten Halbleitermodule unabhängig von dem Modulstrom durch das jeweilige Halbleitermodul erfolgt.

## Patentansprüche

1. Phasenmodul (1) für einen Stromrichter (3) aufweisend
- eine erste Stromschiene (11),
- eine zweite Stromschiene (12) und
- mindestens zwei Halbleitermodule (4),
wobei die erste Stromschiene (11) mit Wechselspannungsanschlüssen (41) der Halbleitermodule (4) verbunden ist, wobei die zweite Stromschiene (12) mit Gleichspannungsanschlüssen (42) der Halbleitermodule (4) verbunden ist, **dadurch gekennzeichnet, dass** die erste und die zweite Stromschiene (11,12) zumindest abschnittsweise in einem Abstand zueinander angeordnet sind, dessen Wert die Hälfte des Wertes des Abstandes zwischen Wechselspannungsanschluss (41) und Gleichspannungsanschluss (42) eines der Halbleitermodule (4) unterschreitet.

2. Phasenmodul (1) nach Anspruch 1, wobei die erste und die zweite Stromschiene (11,12) zumindest abschnittsweise in einem Abstand zueinander angeordnet sind, dessen Wert in der Größenordnung liegt, die eine sichere Isolation zwischen der ersten und zweiten Stromschiene (11,12) sicherstellt.

3. Phasenmodul (1)nach einem der Ansprüche 1 oder 2, wobei die erste und die zweite Stromschiene (11,12) zumindest abschnittsweise in einem Abstand zueinander angeordnet sind, dessen Wert den Wert der Breite oder Dicke der ersten und/oder zweiten Stromschiene (11,12) unterschreitet.

4. Phasenmodul (1) nach einem der Ansprüche 1 bis 3, wobei im Bereich der Halbleitermodule (4) die erste und die zweite Stromschiene (11,12) parallel zueinander angeordnet sind.

5. Phasenmodul (1) nach einem der Ansprüche 1 bis 4, wobei zwischen der ersten Stromschiene (11) und der zweiten Stromschiene (12) ein Isoliermaterial (14) angeordnet ist.

6. Phasenmodul (1) nach einem der Ansprüche 1 bis 5, wobei die erste und/oder die zweite Stromschiene (11,12) mindestens einen Steg (15) aufweist, der rechtwinklig am übrigen Teil der Stromschiene (11,12) angeordnet ist und die Stromschiene (11,12) mit mindestens einem der Gleichspannungsanschlüsse (42) oder einem der Wechselspannungsanschlüsse (41) eines der Halbleitermodule (4) verbindet, wobei der Steg (15) entlang einer Oberfläche des einen Halbleitermoduls (4) angeordnet ist.

7. Phasenmodul (1) nach einem der Ansprüche 1 bis 6, wobei die erste Stromschiene (11) und die zweite Stromschiene (12) in der Umgebung der Halbleitermodule (4) zumindest teilweise überlappend angeordnet sind.

8. Phasenmodul (1) nach Anspruch 7, wobei das Phasenmodul (1) eine dritte Stromschiene (13) aufweist, wobei die dritte Stromschiene (13) mit weiteren Gleichspannungsanschlüssen (43) der Halbleitermodule (4) verbunden ist, wobei die erste Stromschiene (11), die zweiter Stromschiene (12) und die dritte Stromschiene (13) in der Umgebung der Halbleitermodule (4) zumindest teilweise überlappend angeordnet sind.

9. Phasenmodul (1) nach einem der Ansprüche 1 bis 8, wobei die Stromschienen (11,12,13) derart angeordnet sind, dass im Betrieb des Phasenmoduls (1) die durch die jeweiligen Maschen (30) der Modulströme (i₁,i₂,i₃) der einzelnen Halbleitermodule (4) aufgespannten Flächen im Wesentlichen identisch sind.

10. Stromrichter (3) mit mindestens zwei Phasenmodulen (1), insbesondere mit drei Phasenmodulen (1), nach einem der Ansprüche 1 bis 9, wobei die Wechselspannungsanschlüsse (41) der Phasenmodule (1) die Phasen des Stromrichters (3) bilden.

11. Verfahren zum Betreiben eines Phasenmoduls (1) nach einem der Ansprüche 1 bis 9 oder eines Stromrichters (3) nach Anspruch 10, wobei die Ansteuerung der parallel angeordneten Halbleitermodule (4) unabhängig von dem Modulstrom (i₁,i₂,i₃) durch das jeweilige Halbleitermodul (4) erfolgt.

12. Verfahren nach Anspruch 11, wobei die parallel angeordneten Halbleitermodule (4) synchron angesteuert werden.
